# EUROPÄISCHE PATENTANMELDUNG

(11) **EP 1 612 605 A1**
(43) Veröffentlichungstag der Anmeldung: **04.01.2006**
(21) Anmeldenummer: 04015697.8
(22) Anmeldetag: 03.07.2004
(51) Int. Cl.: G03F 7/20

(54) **Laserbelichtung**

(71) Anmelder: Technomedica AG, 8852 Wollerau (CH)
(72) Erfinder: Linder, Patrick, 5318 Mandach (CH)
(74) Vertreter: Troesch Scheidegger Werner AG

(57) **Zusammenfassung**

Eine optische Anordnung zum Übertragen einer Struktur von einer Maske und entsprechendem Belichten eines Substrates (7) weist einen Bereich zum Aufweiten eines Lichtbündels vor der Maske (4) auf und einen Bereich, nachgeschaltet der Maske zum Bündeln des Lichtes. Die Aufweitung des Lichtbündels vor der Maske kann sowohl mittels einer Linsenanordnung erfolgen wie auch mittels einer Spiegeloptik, und analog kann das Bündeln bzw. Zusammenführen des Strahlenbündels mittels einer Linsenanordnung oder einer Spiegeloptik erfolgen. Als Lichtquelle (1) kann eine Laserquelle verwendet werden und als Maske ein Dia oder ein sogenannter Shutter.

## Beschreibung

Die vorliegende Erfindung betrifft eine optische Anordnung gemäss dem Oberbegriff nach Anspruch 1, ein Verfahren zum Belichten von Basisleiterplatten oder Wafer für die Herstellung von Halbleitern bzw. Kleinstschaltkreisen und eine Verwendung der optischen Anordnung.

Schaltungen, wie insbesondere Halbleiterschaltkreise oder sogenannte Chips oder Wafers, werden immer kleiner dimensioniert und zudem werden die darauf angeordneten Schaltkreisstrukturen immer komplizierter bzw. feiner. Entsprechend ist es wichtig, dass die für die Herstellung der Strukturen verwendeten Masken genauer werden und auch die Übertragung mittels insbesondere UV-Licht immer exakter. Die Auflösung derartiger Strukturen beträgt bis zu 90nm.

Die Aufgabe der vorliegenden Erfindung besteht darin Massnahmen vorzuschlagen, die noch feinere Strukturen, insbesondere bei der sogenannten Chip- oder IC-Herstellung, ermöglichen.

Erfindungsgemäss wird die gestellte Aufgabe mittels einer optischen Anordnung gemäss dem Wortlaut nach Anspruch 1 gelöst. Vorgeschlagen wird, dass für das Übertragen einer Struktur von einer Maske und das entsprechende Belichten von Basisleiterplatten für die Herstellung von Kleinstschaltkreisen, wie sogenannten ICs oder Chips, eine optische Anordnung verwendet wird, welche ein Aufweiten eines Lichtbündels vor der Maske ermöglicht und eine Bündelung des durch die Maske hindurchgelangten Lichtes vorgängig dem Belichten der Basisleiterplatte.

Unter Licht verstanden wird sowohl Licht im sichtbaren wie auch im unsichtbaren Bereich, wie beispielsweise UV-, Infrarot-, sichtbarem Spektrum, etc., etc.

Gemäss einer Ausführungsvariante wird vorgeschlagen, dass eine Kollimatorlinse vorgängig der Maske angeordnet wird, um das aufgeweitete Licht parallel zu kollimieren und durch die Maske hindurch zu senden, und dass vor der Basisleiterplatte eine weitere Kollimatorlinse angeordnet wird, um das nach der Maske zusammenlaufende bzw. gebündelte Licht erneut zu kollimieren, um die Basisleiterplatte mittels einem parallel verlaufenden Strahlenbündel zu belichten.

Vorgeschlagen wird insbesondere, dass zunächst von einer Laserquelle das gebündelt emittierte, weitgehendst parallele oder leicht auseinanderlaufende Licht mittels einer Aufweitungslinse, wie insbesondere einer Linse, aufgeweitet wird. Das erzeugte divergierende Licht wird anschliessend vor der Maske mittels einer Kollimatorlinse zu parallelen Lichtstrahlen kollimiert und die so erzeugten parallelen Lichtstrahlen treten durch die Maske hindurch. Nachgeschaltet der Maske wird eine Bündelungslinse verwendet, wie eine Linse die auch aus frequenzverdoppelndem Material gefertigt sein kann. Das nun zusammenlaufende Licht wird erneut durch eine Kollimatorlinse zu einem parallelen Strahlenbündel kollimiert, wobei die parallel verlaufenden Laserstrahlen schlussendlich auf die Basisleiterplatte treffen und die verkleinerte Maskenstruktur übertragen.

Gemäss einer weiteren Ausführungsvariante wird vorgeschlagen, anstelle der vorab beschriebenen Linsen eine Spiegelanordnung zu verwenden, mittels welcher der ursprüngliche Lichtstrahl aufgeweitet, durch die Maske hindurch gesendet und anschliessend mittels einer weiteren Spiegelanordnung erneut zu einem Strahlenbündel mit kleinerem Durchmesser gebündelt wird, um schlussendlich auf eine Basisleiterplatte gerichtet zu werden.

Gemäss einer weiteren Ausführungsvariante wird vorgeschlagen, einen kohärenten Laserstrahl zu verwenden. Dabei wird der ursprüngliche Laser zunächst durch einen halbdurchlässigen Spiegel (Beamsplitter) geteilt, wie beispielsweise exakt 50% zu 50%. Über ein Spiegelsystem wird die eine Wellenlänge um einen gewünschten Bruchteil verzögert und anschliessend werden die beiden Laser wieder zusammengeführt, um so als gerasterter Bruchteilstrahl weiter verwendet zu werden. Anschliessend wird der Laser, wie vorab beschrieben, zunächst aufgeweitet, durch die Maske hindurchgeführt, um anschliessend wieder zusammengeführt und auf die Maskenstruktur geführt zu werden.

Die erfindungsgemäss definierte, optische Anordnung ist insbesondere geeignet für die Herstellung von Kleinstschaltkreisen, wie integrierten Schaltkreisen oder sogenannten ICs wie auch von Kleinstchips. Entsprechend wird erfindungsgemäss ein Verfahren gemäss dem Wortlaut nach Anspruch 8 vorgeschlagen für das Belichten von Kleinstbasisleiterplatten für die Herstellung von integrierten Schaltkreisen bzw. sogenannten Chips oder Wafers.

Weitere bevorzugte Ausführungsvarianten der optischen Anordnung, wie auch des Verfahrens, sind in den abhängigen Ansprüchen charakterisiert.

Die Erfindung wird nun beispielsweise und unter Bezug auf die beigefügten Figuren näher erläutert.

Dabei zeigen:
- Fig. 1: schematisch im Längsschnitt eine erfindungsgemässe optische Anordnung für die Laserbelichtung von Basisleiterplatten oder Wafern,
- Fig. 2: schematisch im Längsschnitt eine Anordnung zur Erzeugung eines kohärenten Lasers, geeignet für die Verwendung in einer optischen Anordnung, dargestellt in Figur 1, und
- Fig. 3 bis 6: schematisch im Längsschnitt weitere Ausführungsvarianten einer erfindungsgemässen optischen Anordnung für die Belichtung einer Basisleiterplatte oder eines Wafers.

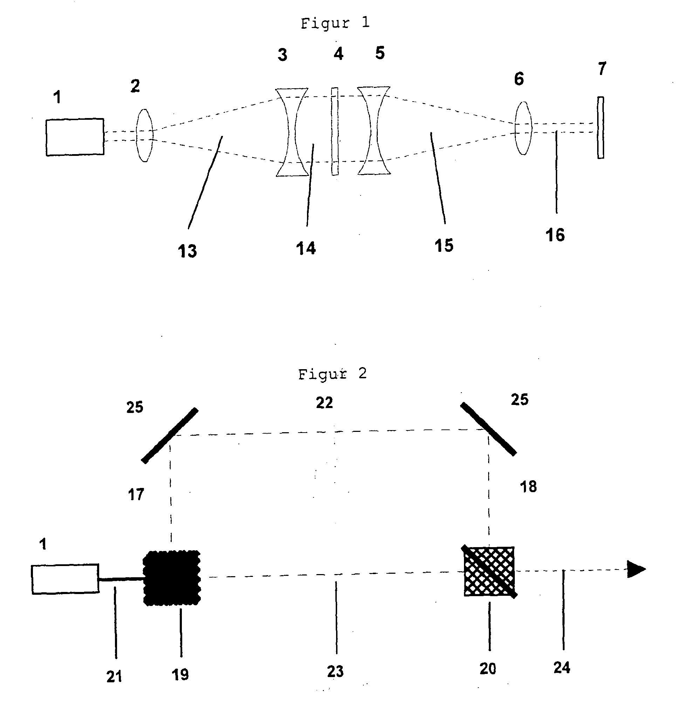

Figur 1 zeigt im Längsschnitt eine erfindungsgemässe optische Anordnung für die Laserbelichtung von Basisleiterplatten oder sogenannte Wafers.

Von einer Laserquelle 1 wird ein parallel verlaufendes Laserstrahlenbündel emittiert. Dieses parallele Strahlenbündel tritt durch eine Aufweitungslinse bzw. Aufweitoptik 2 hindurch, wodurch ein auseinanderlaufendes Strahlenbündel erzeugt wird. Mittels der Kollimatorlinse 3 wird das auseinanderlaufende Strahlenbündel 13 kollimiert, wodurch erneut parallel verlaufende Lichtstrahlen 14 erzeugt werden, welche jedoch einen wesentlich grösseren Durchmesser aufweisen als der ursprüngliche Laser, erzeugt durch die Quelle 1. Dieses parallele Strahlenbündel 14 tritt durch eine Maske 4 hindurch, bei welcher es sich beispielsweise um ein Dia oder einen Shutter handeln kann. Die Maske enthält die zu übertragende Struktur in starker Vergrösserung. Nach Durchtritt durch die Maske 4 wird das aufgeweitete Strahlenbündel 14 mittels der Bündelungslinse 5, einer Linse zu einem konvergierenden Strahlenbündel 15 abgelenkt.

Erneut mittels einer weiteren Kollimatorlinse 6 wird das zusammenlaufende Strahlenbündel 15 in ein parallel verlaufendes Laserstrahlenbündel 16 kollimiert. Der so erzeugte Feinstlaserstrahl 16 trifft schliesslich auf das zu belichtende Basisleitermaterial 7, auf welchem die Halbleiterstruktur zu erzeugen ist.

Der grosse Vorteil der erfindungsgemäss vorgeschlagenen optischen Anordnung liegt darin, dass eine komplizierte Struktur, welche auf einem Halbleiterbasismaterial zu erzeugen ist auf einer relativ grossen Maske erzeugt werden kann, und anschliessend durch Bündelung der Strahlen die Struktur auf die gewünschte Dimension verkleinert werden kann. Dabei kann ein Laserstrahl verwendet werden, welcher zunächst aufgeweitet und nach dem Hindurchtreten durch die Maske wieder gebündelt wird, wobei der Durchmesser des schlussendlichen Lasers in etwa demjenigen des ursprünglichen Laserstrahls entsprechen kann, oder bei Verwendung von frequenzverdoppelndem Material, beispielsweise in der Bündelungslinse 6, sogar die Hälfte oder weniger.

Eine weitere Variante ist die Technologie, kohärente Laser in Anwendung zu bringen.

Figur 2 zeigt entsprechend schematisch im Längsschnitt eine Anordnung für die Erzeugung eines kohärenten Lasers, geeignet für die Verwendung in einer optischen Anordnung, dargestellt in Figur 1.

Der ursprüngliche Laser wird dabei durch einen halbdurchlässigen Spiegel (Beamsplitter) geteilt, wie beispielsweise exakt 50% zu 50%, dann über ein Spiegelsystem um den gewünschten Bruchteil der Wellenlänge verzögert wieder zusammengeführt und so als gerasteter Bruchteilstrahl verwendet, und der Aufweitoptik 2, gemäss Figur 1, zugeführt. Erreicht wird dies durch ein Teilen des Ursprungslaserstrahls 21 durch einen Beamsplitter 19. Der eine Laserstrahl 22 wird durch eine spiegeloptische Verzögerung geführt. Strecke 17 und Strecke 18 stellen die Verzögerung dar. Die leicht gegeneinander phasenverschobenen Laserstrahlen 22 und 23 des Ursprungslaserstrahls 21 werden mit Hilfe einer Spiegeloptik 20 wieder zu einem Laserstrahl 24 zusammengeführt. Durch das Zusammenführen der beiden Laserstrahlen 22 und 23 wird erreicht, dass nur ein Bruchteil der Lichtquantenwelle aktiv belichtet. Beim Zusammenführen wird aufgrund der Phasenverzögerung erreicht, dass ein Teil des Laserstrahls aufgehoben wird und sich nur Bruchstücke der Laserlichtwelle fortsetzen, wie beispielsweise das Wellendach und das Wellental, welche für die weitere optische Anordnung, gemäss Figur 1, verwendet werden. Es hat sich gezeigt, dass dadurch eine sehr hohe Kantenschärfe erreicht werden kann, was auf den Bruchteil der Ursprungswellenlänge zurückzuführen ist. Auf diese Art und Weise ist es möglich, Kleinststrukturen herzustellen in der Grössenordnung von beispielsweise 0,018 µm, d.h. um einen Faktor 10 kleiner bzw. feiner als die heute üblich herstellbaren Strukturen auf Wafers oder sogenannten Chips.

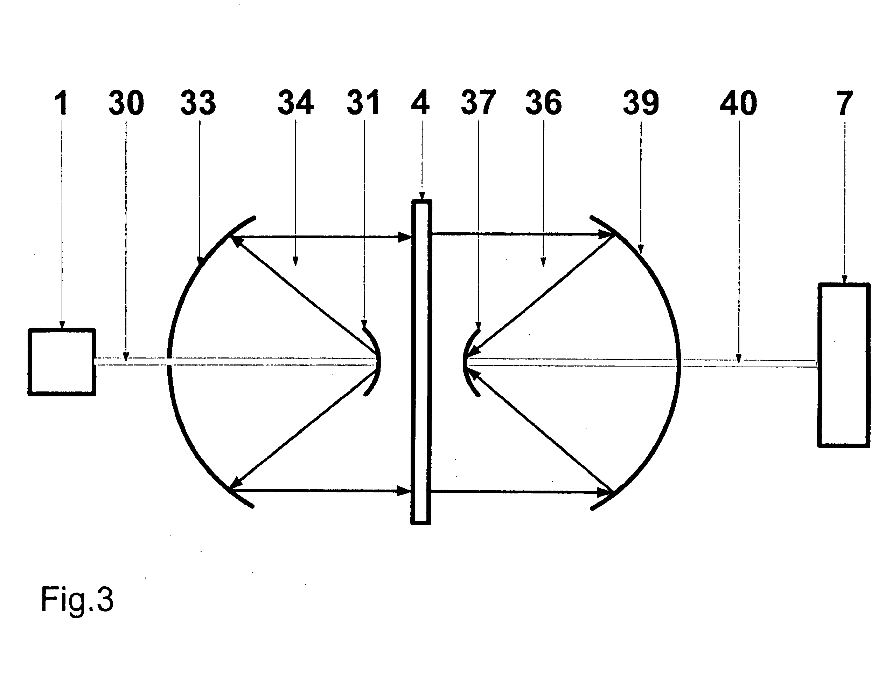

In den Figuren 3 bis 6 sind im Längsschnitt weitere erfindungsgemässe, optische Anordnungen für die Belichtung einer Basisleiterplatte oder eines sogenannten Wafers schematisch dargestellt.

Gemäss Figur 3 wird von einer Lichtquelle 1 ein parallel verlaufendes Lichtstrahlenbündel 30, wie beispielsweise ein Laserstrahlenbündel, emittiert, welches Bündel auf einen konkav gebogenen Spiegel 31, wie einem sogenannten Parabolspiegel, auftrifft und durch Ablenkung aufgeweitet wird. Das so aufweitend abgelenkte Strahlenbündel wird seinerseits auf einen weiteren konkaven Spiegel, wie einen Parabolspiegel 33, reflektiert, wodurch ein aufgeweitetes paralleles Strahlenbündel 34 erzeugt wird.

Analog des Strahlenbündels in Figur 1 wird dieses aufgeweitete Strahlenbündel 34 durch eine Maske 4 hindurch geführt und anschliessend an den Durchtritt trifft das aufgeweitete Strahlenbündel 36, enthaltend die "Maskierung" auf einen weiteren konkaven Hohlspiegel, wie einen Parabolspiegel 39 auf, um erneut durch Reflektion und weiterer Spiegelung am Parabolspiegel 37 zu einem Strahlenbündel 40 mit kleinerem Durchmesser gebündelt zu werden. Schliesslich trifft der so erzeugte Licht- bzw. Laserstrahl 40 auf das zu belichtende Basisleitermaterial 7, auf welchem beispielsweise eine Halbleiterstruktur zu erzeugen ist.

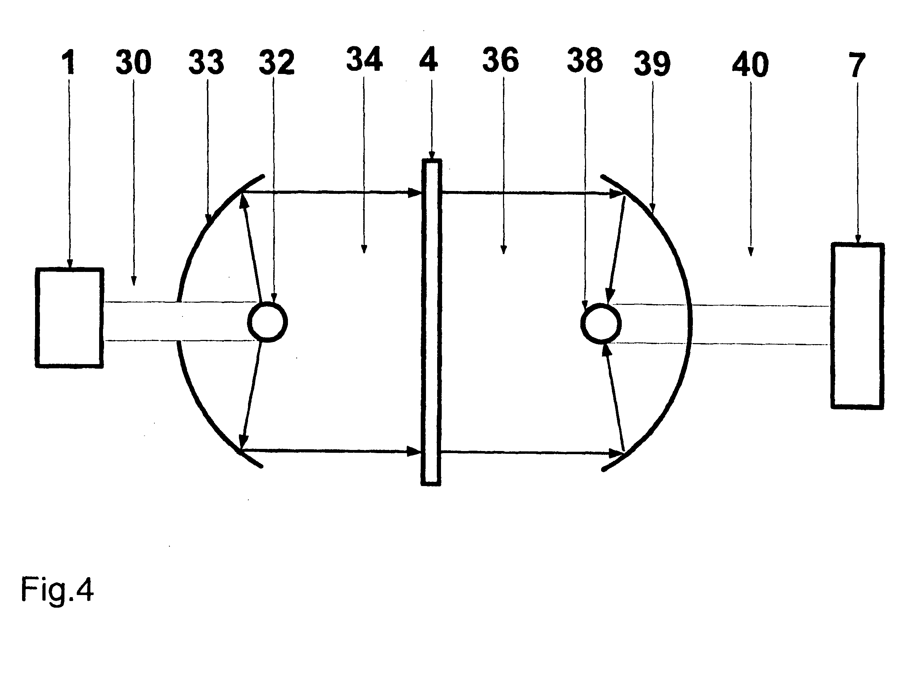

In Figur 4 ist eine zu Figur 3 analoge Anordnung dargestellt, wobei lediglich der erste Spiegel 31 gemäss der Figur 3 ersetzt ist durch eine Spiegelkugel 32, welche beispielsweise eine mittels eines geeigneten Metalls bedampfte Oberfläche aufweisen kann. Die Dimensionen der Kugel 32, wie übrigens selbstverständlich auch der vorab unter Bezug auf Figur 3 und die nachfolgenden Figuren beschriebenen Spiegel, müssen entsprechend derart ausgelegt sein, dass die in den Figuren 3 bis 6 dargestellten Ablenkungen der Lichtstrahlen erhalten werden.

In der Anordnung gemäss Figur 4 ist auch der letzte Spiegel, in Figur 3 bezeichnet mit 37, durch eine Kugel 38 ersetzt, welche wiederum eine mittels eines geeigneten Metalls bedampfte Spiegeloberfläche aufweist.

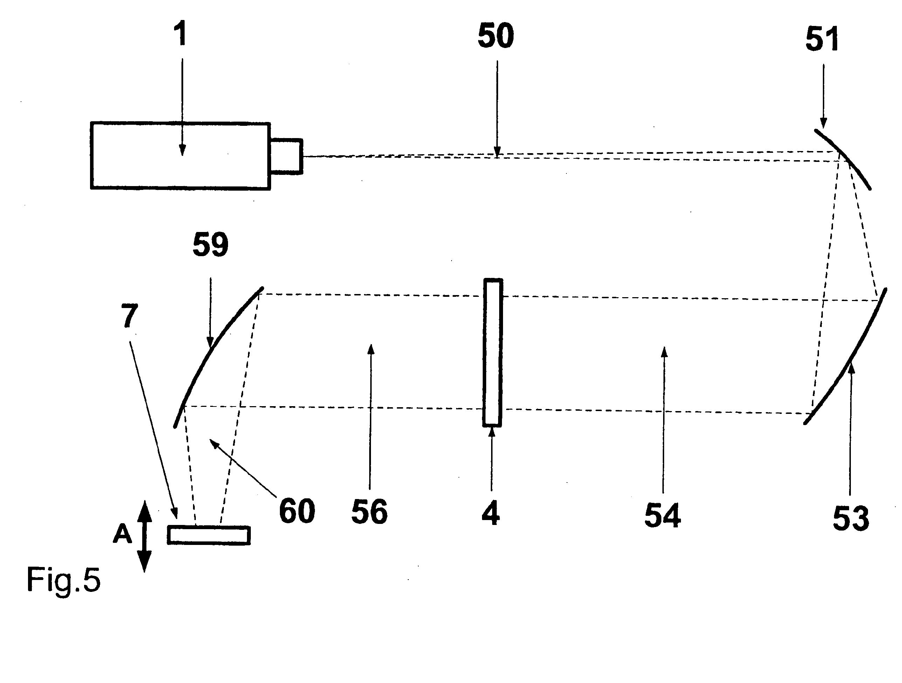

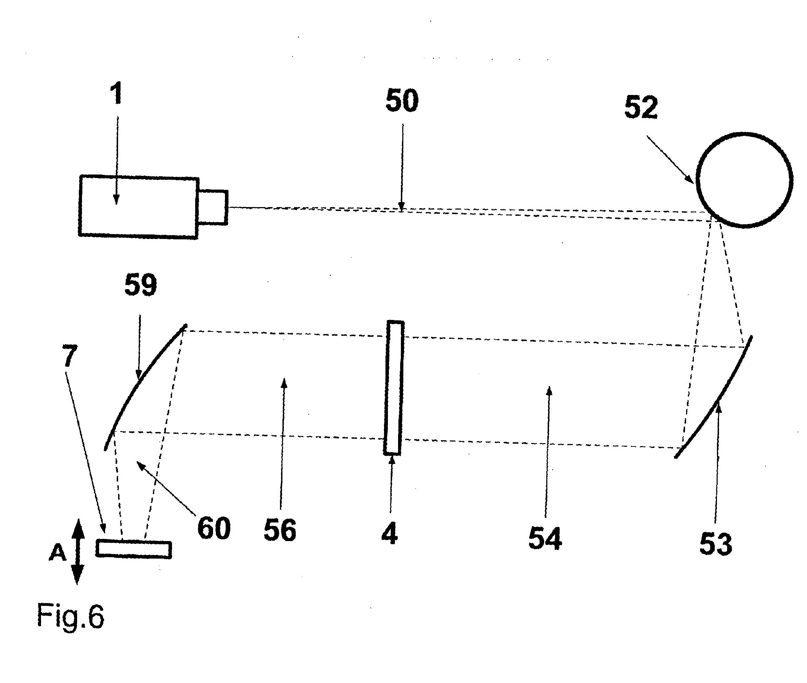

In den Anordnungen gemäss den Figuren 5 und 6 ist eine abweichende Spiegelanordnung dargestellt, bei welcher das von der Lichtquelle 1 emittierte Lichtbündel 50 nicht vollständig parallel ist, sondern in dem der ursprünglich emittierte Lichtstrahl leicht auseinanderlaufend ist. Der Aufweitwinkel kann mittels einer Aufweitoptik in der Lichtquelle eingestellt bzw. beeinflusst werden. Der so leicht auseinanderlaufende Lichtstrahl 50 trifft auf einen ersten Spiegel 51 auf, durch welchen das Strahlenbündel 50 aufgeweitet wird und auf einen weiteren Spiegel 53 übertragen wird, welcher dergestalt ist, dass ein paralleles aufgeweitetes Lichtstrahlenbündel 54 entsteht. Dieses wird erneut durch die Maske 4 hindurch geführt und der die Maskenstruktur enthaltende parallele Lichtstrahl 56 trifft auf einen weiteren Spiegel 59 auf, durch welchen ein zusammenlaufender Lichtstrahl 60 erzeugt wird. Der so zusammenlaufende Lichtstrahl 60 trifft direkt auf das zu belichtende Substrat, wie beispielsweise einen Wafer 7, auf, ohne dass der zusammenlaufende Lichtstrahl, wie unter Bezug auf die vorab beschriebenen Anordnungen zu einem parallelen Lichtbündel bzw. Lichtstrahl gebündelt wird.
Figur 6 zeigt eine zu Figur 5 analoge Anordnung, mit dem Unterschied, dass der erste Spiegel 51 erneut durch eine Kugel 52 ersetzt wird. Die übrigen Elemente wie auch die Funktionsweise sind analog, wie beschrieben unter Bezug auf Figur 5.
Wie bereits vorab erwähnt, besteht ein gewichtiger Unterschied zu den Anordnungen, dargestellt in den Figuren 1 bis 4, darin, dass vor dem Auftreffen des Lichtstrahles auf das Substrat kein paralleles Strahlenbündel erzeugt wird. Der Vorteil dieser Anordnung liegt darin, dass die Grösse der auf dem Substrat zu erzeugenden Struktur variiert werden kann, indem das Substrat bzw. der Wafer 7 in den Pfeilrichtungen A zu bewegen ist. Gegebenenfalls kann das Substrat auch schräg zur Strahlachse angeordnet werden, wenn beispielsweise eine Phasenverschiebung innerhalb des Lichtstrahles auszugleichen ist.

Die erfindungsgemäss beschriebenen Anordnungen wie auch das erfindungsgemäss definierte Verfahren sind selbstverständlich nicht auf eine spezielle Herstellmethode beschränkt. Selbstverständlich eignen sich die Anordnungen wie auch das Verfahren für irgendwelche optische Verfahren, bei welchen eine Struktur von einer Maske auf ein Substrat zu übertragen ist. Mit anderen Worten ist die vorliegende Erfindung keinesfalls auf die Herstellung von Halbleitern, wie Chips, beschränkt, sondern ist überall dort anwendbar, wo mittels optischer Übertragung eine Feinststruktur auf ein Substrat mittels Belichtung zu übertragen ist. Mit anderen Worten handelt es sich beim beschriebenen Herstellverfahren von Leiterplatten, wo Licht-sensitive Beschichtungen, wie sogenannte Fotolacks, für die Herstellung von Feinstschaltkreisen belichtet werden nur um ein typisches Anwendungsbeispiel und keinesfalls ist die vorliegende Erfindung auf diese Anwendung beschränkt.

## Patentansprüche

1. Optische Anordnung zum Übertragen einer Struktur von einer Maske und entsprechendem Belichten eines Substrates, **gekennzeichnet durch** eine Optikanordnung aufweisend einen Bereich zum Aufweiten eines Lichtbündels vor der Maske (4) und eines Bereiches, nachgeschaltet der Maske, zum Bündeln des Lichtes.

2. Anordnung nach Anspruch 1, **dadurch gekennzeichnet, dass** eine Kollimatorlinse (3) angeordnet ist, um das aufgeweitete bzw. divergierende Licht parallel zu kollimieren und durch die Maske (4) hindurch zu senden, und dass vor dem Substrat (7) eine weitere Kollimatorlinse (6) angeordnet ist, um das nach der Maske gebündelte Licht bzw. konvergierende Licht erneut zu kollimieren, um das Substrat mit parallel verlaufendem Strahlenbündel zu belichten.

3. Anordnung nach Anspruch 1, **dadurch gekennzeichnet, dass** eine Spiegeloptik (31, 33, 32, 51, 53, 52) vorgesehen ist, um das Lichtbündel aufzuweiten und parallel zu kollimieren, sowie eine weitere Spiegeloptik (37, 39, 38, 59) um den aufgeweiteten, durch die Maske (4) hindurchgetretenen Strahl erneut gegebenenfalls zu einem parallelen Lichtstrahl mit kleinerem Durchmesser zu bündeln.

4. Anordnung nach einem der Ansprüche 1 oder 3, **dadurch gekennzeichnet, dass** eine Laserquelle (1) verwendet wird, von welcher ein weitgehendst paralleler oder leicht auseinanderlaufender Laserstrahl emittiert wird.

5. Anordnung nach einem der Ansprüche 1 bis 4, **dadurch gekennzeichnet, dass** eine Laserquelle (1) verwendet wird, von welcher ein Laserstrahl auf eine Linse (3) oder ein Spiegel (31, 32, 51, 52) emittiert wird, in welcher oder in welchem das Licht aufgebündelt wird bzw. ein divergierender Lichtstrahl erzeugt wird.

6. Anordnung nach einem der Ansprüche 1 bis 5, **dadurch gekennzeichnet, dass** mindestens eine Optik, wie eine Linse oder eine Spiegelanordnung, verwendet wird zum Aufweiten des Strahlenbündels bzw. zur Erzeugung eines divergierenden oder aufgeweiteten Strahlenbündels und dass nachgeschaltet der Maske eine weitere Linse oder eine Spiegelanordnung verwendet wird zum Bündeln des Lichtes bzw. zur Erzeugung eines konvergierenden Strahlenbündels.

7. Anordnung nach einem der Ansprüche 1 bis 6, **dadurch gekennzeichnet, dass** als Maske ein Dia oder ein sogenannter Shutter verwendet wird.

8. Anordnung nach einem der Ansprüche 1 bis 7, **dadurch gekennzeichnet, dass** Linsen aus frequenzverdoppelndem Material verwendet werden, wodurch die Endwandschärfe kleiner als 1/4 der Ursprungswellenlänge betragen kann, was beispielsweise bedeutet, dass also aus einer Ursprungs-200nm-Struktur eine 100nm-Struktur belichtet wird.

9. Anordnung nach einem der Ansprüche 1 bis 8, **dadurch gekennzeichnet, dass** vorgängig der Linsenanordnung eine Spiegeloptik zur Herstellung eines kohärenten Laserstrahls verwendet wird.

10. Anordnung nach Anspruch 9, **dadurch gekennzeichnet, dass** die Spiegeloptik einen sogenannten Beamsplitter (19) aufweist, geeignet für die Aufteilung des Laserstrahls, der eine Teillaserstrahl derart geführt ist, dass er beim erneuten Zusammenführen mit dem anderen Teil Laser verzögert ist, die beiden Teillaserstrahls mittels eines Beamspleissers oder Mixers (20) überlagert werden, und anschliessend der so hergestellte kohärente Laserstrahl der Linsenanordnung oder Spiegeloptik zugeführt wird.

11. Anordnung nach einem der Ansprüche 1 bis 10, **dadurch gekennzeichnet, dass** das Substrat eine Basisleiterplatte bzw. ein Wafersubstrat ist.

12. Anordnung nach einem der Ansprüche 1 bis 11, **dadurch gekennzeichnet, dass** das zu belichtende Substrat bzw. der Wafer im zusammenlaufenden Lichtstrahl (60), vorzugsweise senkrecht oder gegebenenfalls schräg zur Lichtstrahllängsachse in Lichtstrahllängsrichtung verschieblich angeordnet ist.

13. Verfahren zur Herstellung eines Wafers oder Chips bzw. eines kleinstintegrierten Schaltkreises, **dadurch gekennzeichnet, dass** ein Laserstrahlbündel, wie ein Laserstrahl zunächst aufgeweitet und kollimiert als parallel verlaufendes Strahlenbündel mit grösserem Durchmesser durch eine Maske hindurch emittiert wird, in welcher Maske die zu übertragende Schaltkreisstruktur angeordnet ist und anschliessend das parallel verlaufende, aufgeweitete Strahlenbündel zu einem Laserstrahl mit kleinem Durchmesser zusammengeführt und gegebenenfalls gebündelt wird bzw. die aufgenommene Struktur stark verkleinert wird, um die verkleinerte Struktur auf ein Leiterbasismaterial bzw. Wafersubstrat zu übertragen.

14. Verfahren nach Anspruch 13, **dadurch gekennzeichnet, dass** der Laserstrahl zunächst mittels einer Linse oder einer Spiegelanordnung aufgeweitet, gegebenenfalls mittels einer Kollimatorlinse zu einem parallelen Strahlenbündel kollimiert wird, um als aufgeweitetes paralleles Strahlenbündel durch die Maske hindurch zu gelangen, und die auf der Maske angeordnete Struktur zu übernehmen, anschliessend das aufgeweitete parallel verlaufende Strahlenbündel mittels einer Linse oder einer Spiegelanordnung zu einem konvergierenden Strahlenbündel oder einem Strahlenbündel mit kleinerem Durchmesser transformiert wird, und gegebenenfalls erneut mittels einer Kollimatorlinse zu einem parallel verlaufenden Strahlenbündel kollimiert wird, um die so verkleinerte Struktur von der Maske auf das Substrat, wie das Chipmaterial oder Wafermaterial zu übertragen.

15. Verfahren nach einem der Ansprüche 13 oder 14, **dadurch gekennzeichnet, dass** zunächst das Laserstrahlbündel, wie beispielsweise der UV-Laserstrahl zunächst mittels eines sogenannten Beamsplitters aufgeteilt wird, wie beispielsweise exakt 50% zu 50%, anschliessend der eine Teillaserstrahl verzögert wird und anschliessend die beiden Teillaserstrahlen mittels eines sogenannten Beamspleissers wieder zusammengeführt werden, um anschliessend als phasenverschobenen Bruchteil-Lichtstrahl im sichtbaren oder unsichtbaren Bereich weiter verwendet zu werden, für das Übertragen der Schaltkreisstruktur auf das Leiterbasismaterial.

16. Verfahren nach Anspruch 15, **dadurch gekennzeichnet, dass** die Verzögerung und Überlagerung beispielsweise 1:64 beträgt, womit mit einer normalen Optik eine Linienschärfe von (256nm : 64) = 4nm erreicht wird.

17. Verfahren nach einem der Ansprüche 13 bis 16, **dadurch gekennzeichnet, dass** die Durchführung des Verfahrens bei reduziertem Druck, wie vorzugsweise im Vakuum, ausgeführt wird.

18. Verwendung der optischen Anordnung nach einem der Ansprüche 1 bis 12 für die Herstellung von Kleinstleiterplatten, wie insbesondere von sogenannten Chips, Wafers oder Kleinst-ICs.
